# FASCICULE DE BREVET EUROPEEN

(11) **EP 1 536 439 B1**
(45) Date de publication et mention de la délivrance du brevet: **11.01.2012**
(21) Numéro de dépôt: 04106043.5
(22) Date de dépôt: 24.11.2004
(51) Int. Cl.: H01G 5/18, H01H 59/00, H03H 9/17

(54) **Composant incluant un condensateur variable**
Variablen Kondensator enthaltendes Bauteil
Component comprising a variable capacitor

(30) Priorité: 25.11.2003 FR 0350911
(43) Date de publication de la demande: 01.06.2005
(73) Titulaire: STMICROELECTRONICS S.A., 92120 Montrouge (FR); Commissariat à l'Énergie Atomique et aux Énergies Alternatives, 75015 Paris (FR)
(72) Inventeur: Casset, Fabrice, 38570, Tencin (FR); Bouche, Guillaume, 38000, Grenoble (FR); Rivoire, Maurice, 38240, Meylan (FR)
(74) Mandataire: de Beaumont, Michel

(56) Documents cités:
- DE-A- 4 302 204
- US-A- 5 884 378
- US-A- 6 046 659
- PATENT ABSTRACTS OF JAPAN vol. 1998, no. 11, 30 septembre 1998 (1998-09-30) -& JP 10 154456 A (OMRON CORP), 9 juin 1998 (1998-06-09)
- PATENT ABSTRACTS OF JAPAN vol. 1996, no. 12, 26 décembre 1996 (1996-12-26) -& JP 08 213282 A (MURATA MFG CO LTD), 20 août 1996 (1996-08-20)

## Description

La présente invention concerne un condensateur variable dont la capacité peut être réglée par application à ses bornes d'une tension susceptible de déformer une de ses électrodes.

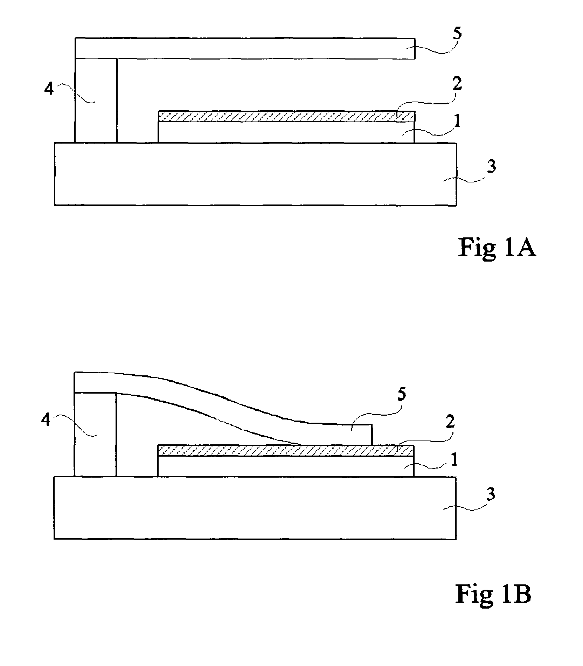

Les figures 1A et 1B sont des vues en coupe d'un exemple de condensateur variable connu dans deux états de fonctionnement. Ce condensateur variable est décrit dans un document de Epoch Technologies sous le titre "A Zipper-Action Differential Micro-Mechanical Tunable capacitor". Une électrode inférieure 1 recouverte d'une couche diélectrique 2 est posée sur un substrat isolant 3. Un plot 4 est posé sur le substrat à côté de la couche conductrice 1. Une électrode supérieure 5 s'appuyant d'un côté sur le plot 4 est placée au-dessus de la couche diélectrique 2 en porte-à-faux. Les électrodes 1 et 5 du condensateur sont reliées à un circuit de commande susceptible d'appliquer une tension entre les électrodes.

A l'état de repos, quand aucune tension n'est appliquée entre les électrodes, l'électrode supérieure 5 est sensiblement horizontale et parallèle à l'électrode inférieure, comme cela est illustré en figure 1A. A l'état d'activation, quand une tension est appliquée entre les électrodes, l'électrode supérieure 5 se déforme du côté non fixé au plot 4 jusqu'à venir en contact avec la couche diélectrique 2, comme cela est illustré en figure 1B. Une fois que l'électrode supérieure est en contact, la portion de l'électrode supérieure située à proximité du point de contact est proche de l'électrode inférieure et avec une faible tension il est possible de l'amener en contact. L'électrode supérieure se déforme ainsi jusqu'à ce que la force de rappel mécanique devienne égale à la force électrostatique exercée entre les électrodes.

Un inconvénient d'une telle structure de condensateur variable est qu'il est nécessaire d'appliquer une forte tension initiale pour déformer l'électrode supérieure jusqu'à ce qu'elle soit en contact avec la couche diélectrique 2.

L'abrégé de brevet japonais 08/213282 (Patent abstracts of Japan, vol 1996, N°12) décrit une structure de condensateur variable comprenant une électrode plane recouvrant le fond d'une cavité et une électrode déformable placée au-dessus de la cavité en appui sur ses bords. L'application d'une tension entre les électrodes entraîne une déformation de l'électrode supérieure et par conséquent une augmentation de la capacité du condensateur. Un inconvénient d'une telle structure de condensateur est qu'il est nécessaire d'appliquer une forte tension pour déformer l'électrode supérieure.

Par ailleurs, la demande de brevet allemand DE 43 02 204 et l'abrégé de brevet japonais 10/154456 (Patent abstracts of Japan, vol 1998, N°11) décrivent des structures de relais comprenant une électrode inférieure posée sur un plan incliné d'un substrat et une électrode supérieure constituée d'une poutre en appui d'un côté sur le substrat au sommet du plan incliné. Des plots métalliques sont placés respectivement au bout de la poutre et sur le substrat au pied du plan incliné. L'application d'une tension entre les électrodes déforme l'électrode supérieure en la rapprochant de l'électrode inférieure jusqu'à mettre en contact les deux plots. Ces structures de relais fonctionnent de façon "binaire". Les électrodes sont écartées ou en contact, et par conséquent ces deux électrodes ne constituent pas un condensateur dont on peut régler la capacité.

Un objet de la présente invention est de prévoir un condensateur variable comportant une électrode mobile déformable avec une faible tension appliquée entre les électrodes du condensateur.

Un autre objet de la présente invention est de prévoir un tel condensateur dont on puisse facilement régler la valeur de capacité.

Un autre objet de la présente invention est de prévoir des composants comprenant un tel condensateur variable.

Pour atteindre ces objets, la présente invention prévoit un condensateur variable comprenant : une portion de sillon formée dans un substrat isolant, deux parties supérieures du substrat situées de chaque côté de la portion de sillon constituant deux bords latéraux, une couche conductrice recouvrant l'intérieur de la portion de sillon, une membrane souple, constituée d'un matériau conducteur, placée au-dessus de la portion de sillon en s'appuyant sur lesdits bords, une couche diélectrique recouvrant la couche conductrice ou la membrane de façon à isoler les portions de la couche conductrice et de la membrane qui sont proches l'une de l'autre, et des bornes d'application d'une tension entre la couche conductrice et la membrane, et tel que la profondeur de la portion de sillon augmente continûment en allant d'un des bords vers le fond de la portion de sillon, et que la couche conductrice recouvre l'intérieur de la portion de sillon au moins jusqu'à l'un des deux bords qu'elle recouvre éventuellement.

Selon un mode de réalisation du condensateur susmentionné, ladite portion de sillon est une portion d'une cavité formée dans le substrat isolant.

Selon un mode de réalisation du condensateur susmentionné, la couche conductrice recouvre l'intérieur de la portion de sillon jusqu'aux deux bords.

Selon un mode de réalisation du condensateur susmentionné, une tranchée est formée dans le substrat, des espaceurs étant accolés contre deux parois opposées de la tranchée, l'espace de la tranchée non occupé par les espaceurs constituant ladite portion de sillon.

Selon un mode de réalisation du condensateur susmentionné, une tranchée est formée dans le substrat, un espaceur étant accolé contre une des parois de la tranchée, l'espace de la tranchée non occupé par les espaceurs constituant ladite portion de sillon, ladite couche conductrice recouvrant ledit espaceur et une grande partie du fond de la portion de sillon située à proximité de l'espaceur, la partie du fond de la portion de sillon située à proximité de la paroi sans espaceur étant découverte.

Selon un mode de réalisation du condensateur susmentionné, la membrane est dans un état de repos quand aucune tension n'est appliquée entre lesdites bornes, l'application d'une tension déformant la membrane en la rapprochant de la couche conductrice, la suppression de la tension ramenant la membrane dans son état de repos.

Selon un mode de réalisation du condensateur susmentionné, ladite portion de sillon comprend plusieurs parties présentant des inclinaisons différentes.

La présente invention prévoit aussi un résonateur comprenant un condensateur tel que décrit précédemment, et comprenant en outre une couche piézoélectrique posée sur la membrane souple, et une seconde couche conductrice posée sur la couche piézoélectrique, ladite couche conductrice et la seconde couche conductrice constituant les électrodes du résonateur.

La présente invention prévoit aussi un interrupteur comprenant un condensateur tel que décrit ci-dessus, et dans lequel ladite couche conductrice comprend deux portions disjointes, chaque portion recouvrant un des côtés de la portion de sillon jusqu'à un des bords, ladite membrane comprend deux portions disjointes placées sensiblement au-dessus des deux portions de ladite couche conductrice, et ladite couche diélectrique recouvre la surface inférieure de la membrane souple, et comprenant en outre au moins une paire de premiers plots conducteurs placés au fond de la portion de sillon entre les deux portions de la couche conductrice et au moins un second plot conducteur encastré dans la couche diélectrique du côté de sa face inférieure, au-dessus des paires de premiers plots conducteurs, les seconds plots conducteurs étant susceptibles de mettre en contact les deux premiers plots de chaque paire après déformation de la membrane par application d'une tension entre la couche conductrice et la membrane.

La présente invention prévoit aussi un procédé de formation d'un condensateur variable comprenant les étapes suivantes : former une cavité dans un substrat isolant, une portion de cavité ayant sensiblement la forme d'une portion de sillon, les parties supérieures du substrat situées à proximité de ladite portion de sillon constituant deux bords latéraux ; recouvrir l'intérieur de la portion de sillon au moins jusqu'à un des bords et recouvrir éventuellement un ou deux bords d'une première couche conductrice ; remplir la cavité d'une portion sacrificielle ; recouvrir la portion sacrificielle, les parties supérieures du substrat et éventuellement les portions de la première couche conductrice placées au-dessus des bords latéraux d'une couche isolante et d'une seconde couche conductrice ; graver la couche isolante et la seconde couche conductrice de façon à conserver une portion en forme de pont passant par-dessus la portion de sillon et s'appuyant sur les bords latéraux ; et éliminer la portion sacrificielle.

Selon un mode de mise en oeuvre du procédé décrit ci-dessus, l'étape de formation d'une cavité dans un substrat isolant comprend les étapes suivantes : former des plots isolants sur une couche support ; recouvrir la couche support et les plots isolants d'une couche isolante ; et effectuer un polissage mécano-chimique de la couche isolante jusqu'à découvrir les plots isolants, le procédé de gravure du polissage étant tel qu'il grave davantage la couche isolante que les plots isolants, les plots isolants constituant lesdits bords latéraux.

Selon un mode de mise en oeuvre du procédé décrit ci-dessus, le procédé comprend en outre préalablement au remplissage de la cavité d'une portion sacrificielle, une étape consistant à former des portions isolantes sur le bord de la cavité, le remplissage de la cavité consistant alors à déposer une couche sacrificielle sur l'ensemble de la structure et à effectuer ensuite un polissage mécano-chimique jusqu'à découvrir les portions isolantes.

Selon un mode de mise en oeuvre du procédé décrit ci-dessus, l'étape consistant à former une cavité dans un substrat comprend les étapes suivantes : prévoir, sur un substrat isolant, un empilement de différentes couches isolantes, une ouverture étant formée dans chacune des couches, les ouvertures étant superposées et de plus en plus grandes en s'éloignant du substrat, chaque ouverture étant placée de façon à découvrir entièrement l'ouverture sous-jacente ; et effectuer un polissage mécano-chimique de la structure précédemment obtenue en utilisant un procédé de gravure tel que les vitesses d'attaque des différentes couches isolantes soient différentes et augmentent en allant du substrat vers le haut de l'empilement.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B sont des vues en coupe d'un condensateur variable connu, précédemment décrit, dans deux états de fonctionnement ;
les figures 2A et 2B sont des vues en coupe d'un exemple de condensateur variable selon la présente invention dans deux états de fonctionnement ;
la figure 3 est une vue en perspective du condensateur représenté en figure 2A ;
les figures 4A à 4H sont des vues en coupe de structures obtenues après des étapes successives d'un procédé de réalisation d'un condensateur variable selon la présente invention ;
les figures 5A et 5B sont des vues en coupe d'un autre exemple de condensateur selon la présente invention ;
les figures 6A et 6B sont des vues en coupe d'un autre exemple de condensateur selon la présente invention ;
la figure 7 est une vue en coupe d'un condensateur selon la présente invention formé dans un sillon présentant de multiples inclinaisons ;
les figures 8A et 8B sont des vues en coupe de structures obtenues après des étapes successives d'un procédé de fabrication d'un sillon présentant de multiples inclinaisons ;
les figures 9A et 9B sont des vues en coupe d'un résonateur comportant un condensateur selon la présente invention ;
la figure 10 est une vue en coupe plus détaillée du résonateur représenté en figures 9A et 9B ;
les figures 11A et 11B sont des vues en coupe d'un microinterrupteur comportant un condensateur selon la présente invention ; et
la figure 12 est une vue de dessus du micro-interrupteur représenté en figures 11A et 11B.

Comme cela est habituel dans la représentation des circuits intégrés, les diverses figures ne sont pas tracées à l'échelle.

Dans une première partie, on décrira un exemple de structure et de procédé de réalisation d'un condensateur selon la présente invention.

Dans une deuxième partie, on décrira deux autres exemples de condensateurs selon la présente invention pouvant être obtenus selon un procédé sensiblement identique.

Dans une troisième partie, on décrira une structure et un procédé de fabrication d'un condensateur comportant une électrode présentant de multiples inclinaisons.

Dans une quatrième partie, on décrira une structure et un procédé de réalisation d'un résonateur comportant un condensateur selon la présente invention.

Dans une cinquième partie, on décrira une structure et un procédé de réalisation d'un microinterrupteur comportant un condensateur selon la présente invention.

### 1. Exemple de condensateur selon la présente invention

### 1.1 Structure

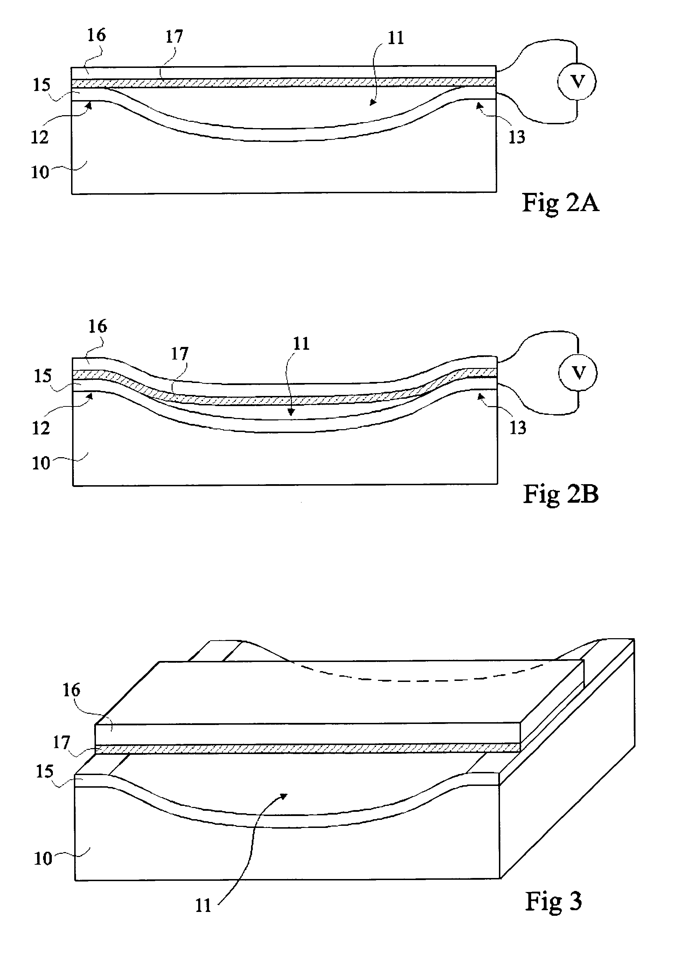

Les figures 2A et 2B sont des vues en coupe d'un condensateur selon la présente invention dans deux états de fonctionnement différents. La figure 3 est une vue en perspective du condensateur représenté en figure 2A. Le condensateur est formé dans un substrat isolant 10, et plus précisément, dans et au-dessus d'une portion de sillon 11 formée dans le substrat isolant 10. Les deux parties supérieures du substrat situées de chaque côté de la portion de sillon 11 constituent deux bords latéraux 12 et 13. Une couche conductrice 15 recouvre l'intérieur de la portion de sillon 11 jusqu'aux deux bords 12 et 13 qu'elle recouvre aussi dans cet exemple. Une membrane 16, constituée d'un matériau conducteur, est placée au-dessus de la portion de sillon 11 et s'appuie sur les bords 12 et 13. Une couche isolante 17 recouvre la surface inférieure de la membrane 16. La couche isolante 17 isole les portions de la couche conductrice 15 et de la membrane 16 qui sont proches l'une de l'autre, notamment au-dessus des bords 12 et 13. Comme cela est visible en figure 3, la membrane 16 recouverte de la couche isolante 17 a sensiblement la forme d'une poutre posée sur les deux bords 12 et 13 de la portion de sillon 11. La couche conductrice 15 et la membrane 16 sont reliées à deux bornes entre lesquelles un circuit de commande V applique une tension sur commande.

Un condensateur selon la présente invention pourra être utilisé comme composant discret ou faire partie d'un circuit intégré. Dans le cas d'un composant discret, la couche conductrice 15 et la membrane 16 sont reliées à des plots de connexion externes. Dans un circuit intégré comprenant de façon générale un substrat semiconducteur dans lequel sont formés des composants actifs tels que des transistors et un réseau d'inter-connexions comportant plusieurs niveaux de métallisations sur lesquels sont formés des lignes conductrices reliées par des vias conducteurs, un condensateur selon la présente invention pourra être placé au-dessus du réseau d'interconnexions, sur un des niveaux de métallisation, ou éventuellement dans une cavité du substrat semiconducteur en prévoyant de placer une couche isolante entre le substrat semiconducteur et le condensateur. De plus, afin de protéger et/ou d'isoler le condensateur d'autres éléments du circuit ou du boîtier dans lequel est inséré le circuit, on pourra placer au-dessus du condensateur une "cloche" de protection constituée par exemple d'une portion isolante en forme de demi-sphère.

A l'état de repos, lorsque le circuit de commande V n'applique pas de tension, la membrane 16 et la couche isolante 17 sont sensiblement horizontales, comme cela est représenté en figures 2A et 3. La capacité du condensateur est alors minimale. Quand le circuit de commande V applique une tension, la membrane 16 se déforme progressivement en se rapprochant de la couche conductrice 15, comme cela est représenté en figure 2B. L'amplitude de la déformation est d'autant plus élevée que la tension appliquée par le circuit de commande V est élevée. Ainsi, à une valeur de tension donnée correspond une capacité, la capacité étant d'autant plus élevée que la tension est élevée.

Selon un aspect de la présente invention, la profondeur de la portion de sillon 11 augmente continûment en allant des bords 12 et 13 du sillon vers le fond du sillon. Cette caractéristique structurelle permet qu'une déformation de la membrane 16 puisse être effectuée avec une faible tension. En effet, les portions de la couche 15 et de la membrane 16 situées à proximité des bords 12 et 13 de la portion de sillon 11 sont proches l'une de l'autre et une faible tension entre elles permet de les rapprocher. Une fois ces premières portions rapprochées, les portions de la couche conductrice 15 et de la membrane 16 situées juste à côté sont alors proches l'une de l'autre et une faible tension permet de les rapprocher et ainsi de suite. La membrane 16 se déforme jusqu'à ce que la force de rappel "mécanique" de la membrane devienne égale à la force électrostatique créée entre la couche 15 et la membrane 16, la force électrostatique étant sensiblement proportionnelle à la tension appliquée par le circuit de commande V.

Un avantage d'un condensateur selon la présente invention est qu'il est possible de régler sa capacité avec une très faible tension.

### 1.2 Procédé de formation d'un condensateur

Un condensateur selon la présente invention peut être réalisé selon le procédé décrit ci-après.

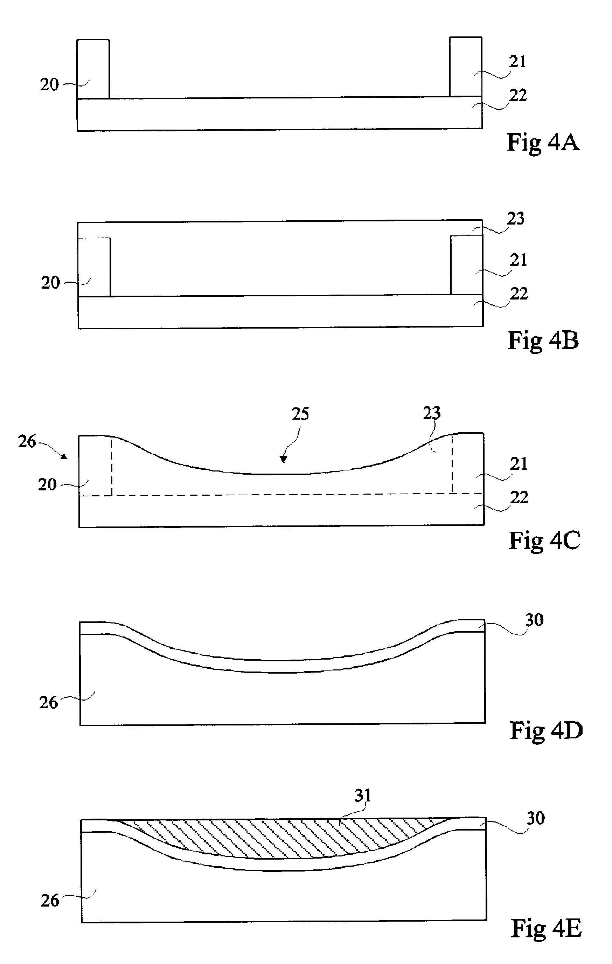

Dans une étape initiale, illustrée en figure 4A, on forme des plots isolants 20 et 21 sur une couche support 22. Les plots isolants 20 et 21 sont en contact avec d'autres plots isolants non représentés de façon à entourer une portion découverte de la surface supérieure de la couche support 22. La couche support 22 pourra être le substrat semiconducteur du circuit intégré ou une des couches du réseau d'interconnexions du circuit intégré. Les plots isolants 20 et 21 sont par exemple en nitrure.

A l'étape suivante, illustrée en figure 4B, on recouvre la couche support 22 et les plots isolants 20 et 21 d'une couche isolante 23. La couche isolante 23 est par exemple en oxyde de silicium SiO₂.

A l'étape suivante, illustrée en figure 4C, on effectue un polissage mécano-chimique de la couche isolante 23 jusqu'à découvrir les plots isolants 20 et 21. Le procédé de gravure mis en oeuvre lors du polissage est choisi tel qu'il "attaque" davantage la couche isolante 23, en SiO₂, que les plots 20 et 21, en nitrure. Lorsque les plots 20 et 21 sont relativement écartés, il se forme un creux dans la couche isolante 23 entre les plots 20 et 21. Le phénomène, connu sous le nom anglais "dishing", est généralement non souhaitable car il conduit à la formation de surfaces non planes. Cependant, ce phénomène est mis à profit dans le procédé de la présente invention pour la formation d'une portion de sillon 25 entre les plots 20 et 21 constituant deux bords latéraux de la portion de sillon 25. La portion de sillon 25 est en fait une portion de la cavité formée dans la couche isolante 23 lors du polissage mécano-chimique.

Le procédé décrit en relation aux figures 4A à 4C est un exemple de procédé permettant de réaliser une portion de sillon 25 dans un substrat isolant. Dans l'exemple du procédé décrit ci-dessus, les plots isolants 20, 21 et la couche isolante 23 constituent un substrat isolant 26. D'autres procédés de formation d'une portion de sillon 25 dans un substrat 26 peuvent être utilisés.

A l'étape suivante, illustrée en figure 4D, on recouvre l'intérieur de la portion de sillon 25 d'une couche conductrice 30 s'étendant jusqu'aux bords de la portion du sillon 25 et éventuellement au-dessus des bords du sillon.

A l'étape suivante, illustrée en figure 4E, on remplit la portion de sillon 25 d'une portion sacrificielle 31. La portion sacrificielle 31 ne recouvre pas les bords de la portion de sillon 25. La portion sacrificielle 31 est par exemple constituée d'une résine. La portion sacrificielle 31 peut être formée en déposant une couche sacrificielle sur la structure obtenue précédemment et en effectuant ensuite un polissage mécano-chimique de cette couche sacrificielle jusqu'à découvrir la couche conductrice 30.

Selon une variante de l'étape susmentionnée, on dépose une fine couche isolante, par exemple en oxyde de silicium, sur la structure telle que représentée en figure 4D. On grave ensuite cette fine couche isolante de façon à découvrir la portion de la couche conductrice située dans la portion de sillon, en conservant des portions de couche isolante sur les bords de la portion de sillon 25. On dépose ensuite une couche sacrificielle sur l'ensemble de la structure et on effectue un polissage mécano-chimique jusqu'à découvrir les portions de couche isolante placées sur les bords de la portion de sillon 25. Cette variante de fabrication permet de délimiter de façon plus précise la portion de couche sacrificielle, ceci permettrait au final de définir plus précisément les caractéristiques géométriques du condensateur.

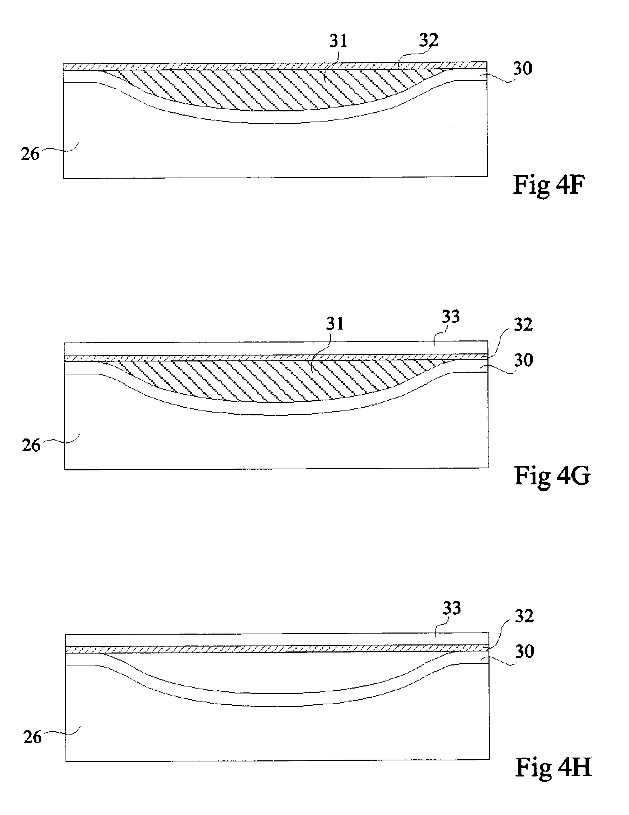

A l'étape suivante, illustrée en figure 4F, on forme une couche isolante 32 qui recouvre la portion sacrificielle 31 et les portions de la couche conductrice 30 situées sur les bords de la portion de sillon 25. La couche isolante 32 est par exemple une couche de nitrure SiN.

A l'étape suivante, illustrée en figure 4G, on recouvre la couche isolante 32 d'une couche conductrice 33. Les couches conductrices 30 et 33 peuvent être constituées de matériaux identiques ou différents tel que de l'aluminium, du cuivre ou de l'or.

A l'étape suivante, illustrée en figure 4H, on grave la couche conductrice 33 et la couche isolante 32 de façon à former une poutre placée au-dessus de la portion de sillon 25. On élimine ensuite la portion sacrificielle 31.

### 2. Autres exemples de condensateurs selon la présente invention

### 2.1 Structure d'un premier autre exemple

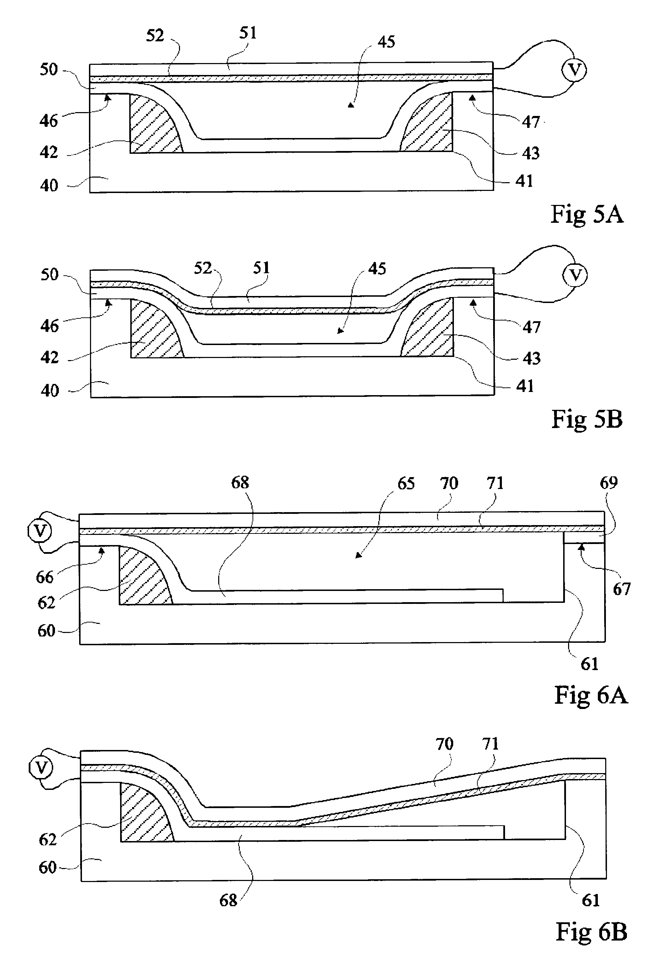

Les figures 5A et 5B sont des vues en coupe d'un condensateur selon la présente invention ayant une forme particulière obtenue selon un procédé décrit ci-après. Le condensateur est formé au-dessus d'un substrat isolant 40 dans lequel est formée une tranchée 41 sensiblement parallélépipédique. Des espaceurs 42 et 43 sont placés contre deux parois opposées de la tranchée 41 et posés sur le fond de la tranchée 41. La partie découverte des espaceurs 42 et 43 a une forme courbe entre les bords supérieurs de la tranchée 41 et le fond de la tranchée. La partie de la tranchée 41 non occupée par les espaceurs 42 et 43 constitue une portion de sillon 45. Les parties supérieures du substrat situées à proximité de la portion de sillon 45 (ou de la tranchée 41) constituent deux bords latéraux 46 et 47. Grâce à la présence des espaceurs 42 et 43, la profondeur de la portion de sillon 45 augmente continûment en allant des bords du sillon vers le fond du sillon.

Comme pour le condensateur représenté en figure 2A, une couche conductrice 50 recouvre l'intérieur de la portion de sillon 45. Une membrane souple 51, constituée d'un matériau conducteur, est placée au-dessus de la portion de sillon 45 et s'appuie sur les portions de la couche conductrice 50 recouvrant les bords 46 et 47 de la portion de sillon. Une couche isolante 52 recouvrant dans cet exemple la surface inférieure de la membrane souple 51 isole la couche conductrice 50 et la membrane souple 51. La couche conductrice 50 et la membrane souple 51 sont reliées à deux bornes entre lesquelles un circuit de commande V applique une tension sur commande.

A l'état de repos, lorsque le circuit de commande V n'applique pas de tension, la membrane 51 et la couche isolante 52 sont sensiblement horizontales, comme cela est représenté en figure 5A. Quand le circuit de commande V applique une tension, la membrane 51 se déforme et se colle progressivement contre la couche conductrice 50, comme cela est illustré en figure 5B. En faisant varier la tension appliquée par le circuit de commande V il est possible d'ajuster la capacité du condensateur.

### 2.2 Structure d'un second autre exemple

Les figures 6A et 6B sont des vues en coupe d'un autre exemple de condensateur selon la présente invention. Le condensateur est formé au-dessus d'un substrat isolant 60 dans lequel est formé une tranchée 61 ayant une forme sensiblement parallélépipédique. Un espaceur 62 est placé contre l'une des parois verticales de la tranchée 61. La partie découverte de l'espaceur 62 a une forme courbe comme les espaceurs 42 et 43 du condensateur des figures 5A et 5B. La partie de la tranchée 61 non occupée par l'espaceur 62 constitue une portion de sillon 65. Les parties supérieures du substrat 60 situées à proximité de la portion de sillon 65 constituent deux bords latéraux 66 et 67. Du côté de l'espaceur 62, la profondeur de la portion de sillon 65 augmente continûment en allant du bord 66 vers le fond du sillon. De l'autre côté du sillon, à proximité du bord 67, la profondeur du sillon est maximale.

Selon un aspect de cet exemple de condensateur, une couche conductrice 68 recouvre le bord 66, l'espaceur 62 et une grande partie du fond de la portion du sillon 65. La couche conductrice 68 ne recouvre pas la paroi verticale située à proximité du bord 67 ni une partie du fond de la portion de sillon 65 située à proximité de cette paroi.

Comme pour les condensateurs décrits ci-dessus, le condensateur des figures 6A et 6B comprend une membrane souple 70 placée au-dessus de la portion de sillon 65 en s'appuyant sur les bords 66 et 67 de la portion de sillon 65, au-dessus de la couche conductrice 68. Une couche isolante 71 placée dans cet exemple sur la face inférieure de la membrane souple 70 permet d'isoler la couche conductrice 68 et la membrane souple 70. La couche conductrice 68 et la membrane 70 sont reliées à deux bornes entre lesquelles un circuit de commande V applique une tension sur commande.

A l'état de repos, lorsque le circuit de commande V n'applique pas de tension, la membrane 70 et la couche isolante 71 sont sensiblement horizontales, comme cela est représenté en figure 6A. Quand le circuit de commande V applique une tension, la membrane 70 se déforme et se colle progressivement contre la couche conductrice 68. La membrane souple 70 se colle d'abord contre la partie de la couche conductrice 68 située au-dessus de l'espaceur 62, puis progressivement sur la partie de la couche conductrice 68 placée sur le fond de la portion de sillon 65, comme cela est représenté en figure 6B. Plus la tension est élevée plus la partie collée de la membrane est importante.

Un avantage d'un condensateur tel que représenté en figures 6A et 6B est qu'il est possible de régler plus finement sa capacité.

Les condensateurs décrits ci-dessus sont des exemples de condensateurs selon la présente invention. De façon générale, un condensateur selon la présente invention comprend une électrode fixe recouvrant une portion d'une cavité formée dans un substrat isolant, une électrode mobile placée au-dessus de la cavité sensiblement à la verticale de l'électrode fixe et une couche diélectrique placée entre les deux électrodes. La cavité peut avoir diverses formes en vue de dessus. Dans les exemples susmentionnés, la cavité a une forme sensiblement rectangulaire, mais elle pourrait être circulaire, ovale ou tout autre. Quelle que soit la forme de la cavité en vue de dessus, la portion de cavité recouverte par l'électrode fixe a en vue en coupe une forme de sillon. La portion de cavité en forme de sillon est telle que sa profondeur augmente continûment en allant des bords du sillon vers le fond du sillon.

### 2.3 Procédé de fabrication des autres exemples de condensateurs

Les condensateurs décrits en relation aux figures 5A/5B et 6A/6B peuvent être obtenus selon un procédé comportant d'une part la formation d'une portion de sillon 45 ou 65 et d'autre part la formation des électrodes isolées. Le procédé de formation d'une portion de sillon 45 ou 65 consiste à former une tranchée dans un substrat isolant puis à former des espaceurs contre les parois de la tranchée. Dans le cas où l'on souhaite avoir un espaceur uniquement contre l'une des parois de la tranchée, on pourra éliminer un des deux espaceurs formés. Les espaceurs peuvent être formés selon un procédé classique consistant à effectuer un dépôt conforme par exemple de nitrure puis à effectuer une gravure anisotrope du nitrure. Un autre procédé de formation d'espaceurs consiste à effectuer un dépôt conforme d'une fine couche isolante, par exemple en nitrure, au fond, sur les parois et sur le bord de la tranchée 41 ou 61 puis à effectuer un autre dépôt d'une seconde couche isolante, par exemple d'oxyde de silicium, de façon à ce que la tranchée 41 ou 61 soit totalement remplie et enfin à effectuer un polissage mécano-chimique utilisant un procédé de gravure chimique sélectif de façon à graver la seconde couche isolante plus rapidement que la fine couche isolante. La partie de la couche isolante située au milieu de la tranchée se gravant plus rapidement que les parties situées contre les parois de la tranchée, il se forme des espaceurs contre les parois de la tranchée.

Une fois la portion de sillon 45 ou 65 formée, les électrodes isolées peuvent être formées selon un procédé similaire à celui décrit en relation aux figures 4D à 4H. Dans le cas du condensateur décrit en relation aux figures 6A et 6B, on prévoira une étape supplémentaire consistant à graver certaines parties de la couche conductrice déposées à l'intérieur de la portion de sillon, et sur le bord 67 afin d'éliminer les parties de la couche conductrice situées à proximité de la paroi de la tranchée sans espaceur.

### 3. Structure et procédé de fabrication d'un condensateur placé dans un sillon à multiples inclinaisons

Lorsque la profondeur de la portion de sillon dans laquelle est formée un condensateur selon la présente invention diminue très régulièrement en allant des bords vers le fond du sillon, le problème suivant peut apparaître. Contrairement aux représentations d'un condensateur selon la présente invention présentées précédemment, et notamment en figures 2A, 2B, 3, la longueur de l'électrode fixe placée au fond du sillon est bien plus grande que la profondeur du sillon. De plus, lors d'une réalisation d'une portion de sillon selon le procédé décrit précédemment en relation aux figures 4A à 4C, le profil du sillon obtenu varie en fonction de divers paramètres tels que les conditions de polissage mécano-chimique, les caractéristiques géométriques de la cavité hébergeant la portion de sillon sur laquelle est formée le condensateur. Or, plus les profils de sillon sont différents plus les caractéristiques des condensateurs associés divergent. En conséquence, pour une tension donnée appliquée entre les électrodes du condensateur, on peut observer des valeurs de capacité sensiblement différentes.

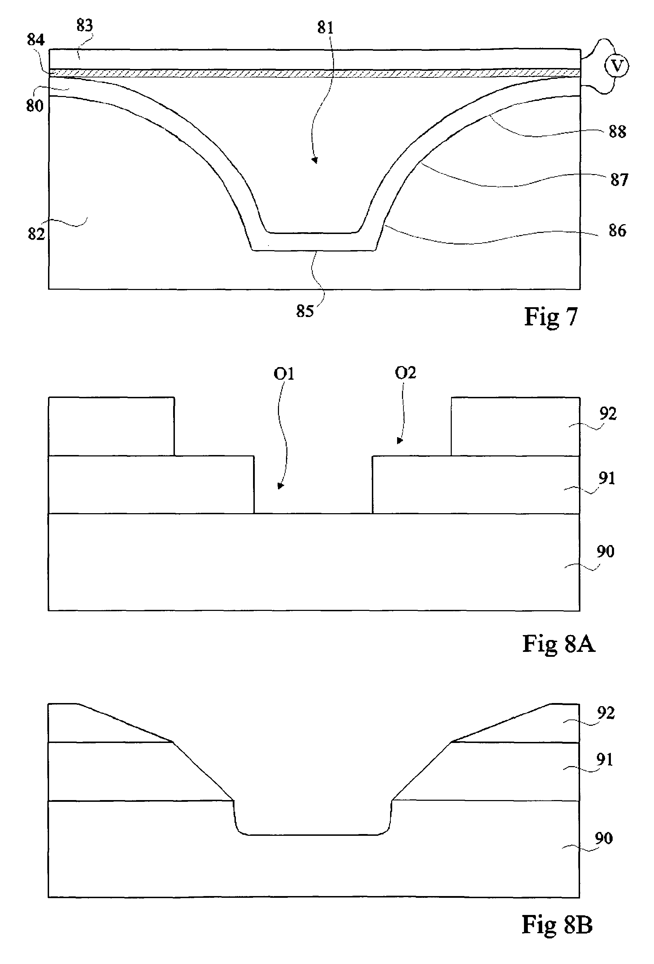

La figure 7 est une vue en coupe d'un condensateur selon la présente invention formé dans un sillon ayant un profil permettant de pallier au problème susmentionné. Le condensateur comprend une électrode fixe 80 recouvrant l'intérieur d'une portion de sillon 81 formée dans un substrat isolant 82, une électrode mobile 83 placée au-dessus de la portion de sillon 81 et une couche isolante 84 placée sous l'électrode mobile 83. Le condensateur est formé dans une portion de sillon 81 dont la profondeur augmente de plus en plus rapidement en allant des bords du sillon vers le fond du sillon. Le fond 85 du sillon est dans cet exemple sensiblement plat. En allant du fond vers un des bords du sillon, on distingue trois parties de la surface supérieure du sillon 86, 87 et 88. La partie 86 est fortement inclinée, la partie 87 moyennement inclinée et la partie 88 faiblement inclinée. L'électrode fixe 80 du condensateur a une forme semblable à la portion de sillon 81. Chaque côté de l'électrode comprend trois portions dont les inclinaisons augmentent en allant des bords du sillon vers le fond du sillon.

Lorsque l'on souhaite augmenter la capacité du condensateur en "collant" de plus en plus l'électrode mobile sur l'électrode fixe, il est nécessaire d'augmenter significativement la tension appliquée lorsque l'électrode fixe aborde une "rupture de pente" pour se coller sur une portion plus inclinée. A contrario, on peut définir une valeur de tension appliquée entre les électrodes qui corresponde à un recouvrement d'un nombre donné de portions de l'électrode fixe, la force électrostatique induite par cette tension ne permettant pas que l'électrode mobile atteigne la portion suivante de l'électrode fixe qui présente une inclinaison supérieure. Le découpage de l'électrode fixe en plusieurs portions d'inclinaisons différentes permet ainsi de définir plus précisément la surface d'électrodes en regard pour une tension donnée appliquée entre les électrodes. En conséquence, il est possible de définir plus précisément la capacité du condensateur correspondant à une tension donnée appliquée entre les électrodes.

Un condensateur comportant une électrode fixe multi-inclinaisons peut être obtenu selon le procédé décrit ci-après.

Dans une première étape, illustrée en figure 8A, on dépose sur un substrat isolant 90, une première couche isolante 91. On forme ensuite une ouverture 01 dans la première couche isolante 91 jusqu'à découvrir la surface supérieure du substrat 90. On dépose alors une seconde couche isolante 92 sur l'ensemble de la structure précédemment obtenue. Puis on forme une ouverture 02 dans la seconde couche isolante 92 au-dessus de l'ouverture 01, l'ouverture 02 étant plus grande que l'ouverture 01. L'ouverture 02 est telle que les portions de la couche isolante 91 situées tout autour de l'ouverture 01 sont découvertes.

A l'étape suivante, illustrée en figure 8B, on effectue un polissage mécano-chimique de la structure précédemment obtenue. Le procédé de gravure utilisé est tel que les vitesses de gravure sont différentes pour chacune des couches isolantes et pour le substrat, la seconde couche isolante 92 se gravant plus rapidement que la première couche isolante 91, elle-même se gravant plus rapidement que le substrat 90. L'épaisseur de la seconde couche isolante diminue sensiblement et ses flancs, du côté de l'ouverture 02, sont largement rabotés. Les flancs de la première couche isolante 91 sont eux aussi rabotés. De plus, il se forme une cavité dans le substrat 90, sensiblement à l'aplomb de l'ouverture 01 de la première couche isolante 91. On obtient alors, en vue en coupe, un sillon comportant des portions d'inclinaisons différentes, l'inclinaison des portions du sillon correspondant aux flancs de la seconde couche isolante 92 étant supérieure à l'inclinaison des portions du sillon correspondant aux flancs de la première couche isolante 91. De même, l'inclinaison des portions du sillon correspondant aux flancs de la première couche isolante 92 est supérieure à l'inclinaison des portions du sillon correspondant aux parois de la cavité formée dans le substrat 90.

De façon générale, l'homme de l'art saura mettre en oeuvre un procédé similaire pour réaliser des sillons présentant un nombre souhaité de portions diversement inclinées.

### 4. Résonateur

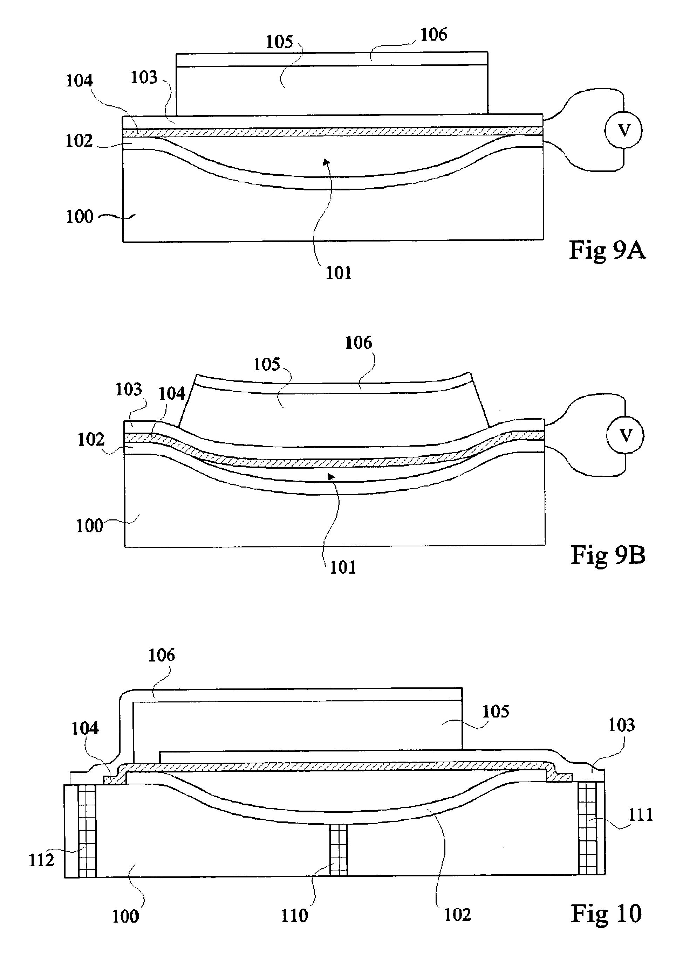

Les figures 9A et 9B sont des vues en coupe d'un résonateur comportant un condensateur selon la présente invention. Le condensateur du résonateur est identique à celui représenté en figure 2A. Le condensateur est formé dans un substrat isolant 100 dans lequel est formée une portion de sillon 101. Une couche conductrice 102 recouvre l'intérieur de la portion de sillon 101 ainsi que ses bords. Une membrane souple 103 est placée au-dessus de la portion de sillon 101 en s'appuyant sur ses bords. La membrane 103 et la couche conductrice 102 sont isolées par une couche isolante 104 recouvrant la surface inférieure de la membrane 103. Comme précédemment, la membrane 103 et la couche conductrice 102 sont reliées à deux bornes entre lesquelles un circuit de commande V applique une tension sur commande.

La membrane souple 103 constitue dans cet exemple l'électrode inférieure du résonateur. Une portion d'un matériau piézoélectrique 105 est posée sur la membrane 103 au-dessus de la portion de sillon 101. La portion piézoélectrique 105 est recouverte d'une couche conductrice 106 constituant l'électrode supérieure du résonateur.

Le fonctionnement d'un tel résonateur est décrit dans le brevet français N°0302817 (référence interne B5861) de la demanderesse. Un changement de la capacité du condensateur sur lequel est placé le résonateur permet d'ajuster sa fréquence de résonance. De plus, comme cela est représenté en figure 9B, lorsque la membrane 103 est déformée pour régler la capacité du condensateur, la portion piézoélectrique 105 se déforme légèrement sur les bords. Cette déformation localisée des bords du résonateur permet de supprimer des réflexions non voulues, ou résonances parasites, qui nuisent à la qualité du résonateur.

La figure 10 est une vue en coupe du résonateur représenté en figures 9A et 9B dans lequel sont représentées les connexions entre les électrodes du condensateur et d'autres éléments du circuit intégré dans lequel est placé le résonateur. Un résonateur tel que décrit précédemment est dans cet exemple placé au-dessus du réseau d'interconnexions du circuit intégré. La couche conductrice 102 peut être facilement reliée au réseau sous-jacent par l'intermédiaire d'un via conducteur 110. Afin de relier l'électrode inférieure du résonateur, la membrane souple 103, on pourra prolonger la couche isolante 104 au-delà de la couche conductrice 102 jusqu'à atteindre le substrat isolant 100 et enfin prolonger la membrane 103 au-dessus du prolongement de la couche isolante 104 jusqu'à atteindre une portion du substrat isolant 100 dans laquelle on aura placé un via conducteur 101 allant jusqu'au réseau d'interconnexions. Afin de relier l'électrode supérieure du résonateur, la couche conductrice 106, on pourra prévoir de prolonger la portion piézoélectrique 105 d'un côté de la membrane souple 103 jusqu'à atteindre la couche isolante 104 que l'on prolongera aussi au-delà de la couche conductrice 102 jusqu'à atteindre le substrat isolant 100 puis on prolongera la couche conductrice 106 le long d'un des flancs de la portion piézoélectrique 105 jusqu'à atteindre la couche isolante 104 et une portion du substrat 100 dans laquelle on aura placé un via conducteur 112.

D'autres modes de connexion des diverses électrodes pourront être imaginés par l'homme de l'art.

### 5. Microinterrupteur

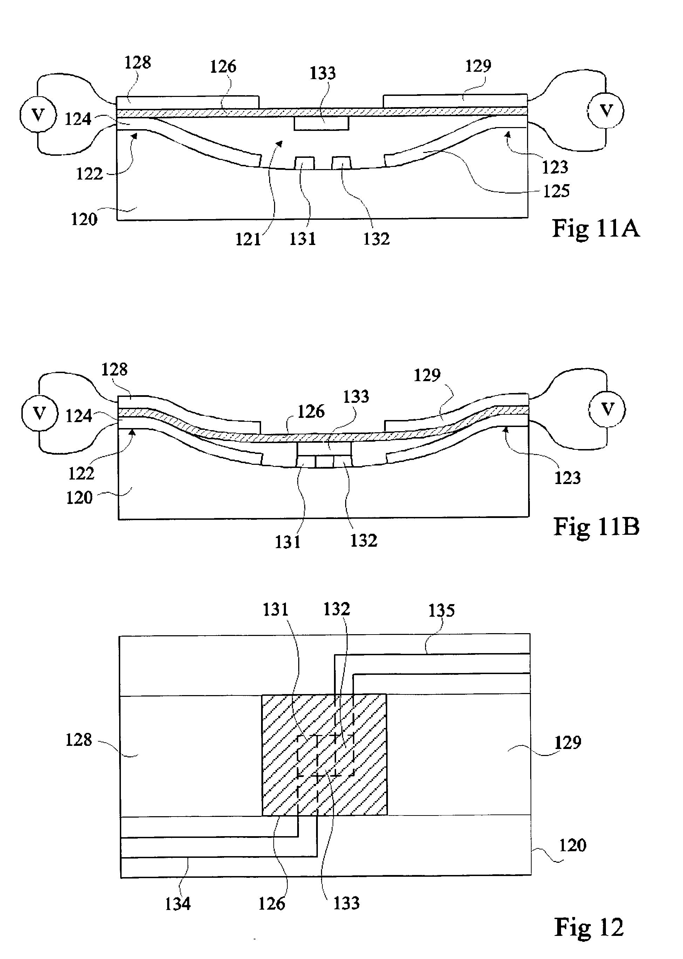

Les figures 11A et 11B sont des vues en coupe d'un micro-interrupteur comportant un condensateur selon la présente invention. La figure 12 est une vue de dessus du micro-interrupteur représenté en figures 11A et 11B. Le microinterrupteur est formé dans un substrat isolant 120 dans lequel est formée une portion de sillon 121. Les parties supérieures du substrat isolant 120 situées à proximité de la portion de sillon 121 constituent deux bords latéraux 122 et 123. Deux portions 124 et 125 de couche conductrice recouvrent chacune un côté de la portion de sillon 121. La portion 124 s'étend sensiblement du fond du sillon 121 au bord 122 qu'elle recouvre. De même, la portion 125 s'étend sensiblement du fond du sillon 121 jusqu'au bord 123 qu'elle recouvre. Une couche isolante 126 en forme de pont est placée au-dessus du sillon 121 et s'appuie sur les bords 122 et 123, plus précisément sur les portions de couche conductrice 124 et 125 recouvrant les bords 122 et 123. Deux portions de couche conductrice 128 et 129 sont placées sur la couche isolante 126 sensiblement au-dessus des portions de couche conductrice 124 et 125. Deux plots conducteurs 131 et 132 sont placés dans le fond du sillon 121 entre les deux portions de couche conductrice 124 et 125. Un plot conducteur 133 est encastré dans la couche isolante 126 du côté de sa face inférieure. Le plot 133 est placé au-dessus des plots conducteurs 131 et 132. Les plots conducteurs 131 et 132 sont reliés respectivement à deux lignes conductrices 134 et 135 placées dans la portion de sillon 121 et visibles en figure 12 de chaque côté de la couche isolante 126 en forme de pont. Les portions 124 et 125 constituent l'électrode inférieure du condensateur. Les portions conductrices 128 et 129 constituent l'électrode supérieure du condensateur. Les électrodes inférieure et supérieure sont reliées à deux bornes entre lesquelles une tension peut être appliquée.

A l'état de repos, lorsqu'aucune tension n'est appliquée entre les électrodes du condensateur, la couche isolante 126 et l'électrode supérieure sont sensiblement horizontales comme cela est représenté en figure 11A. Lorsqu'une tension est appliquée entre les électrodes inférieure et supérieure du condensateur, l'électrode supérieure se déforme jusqu'à ce que le plot 133 soit en contact avec les plots 131 et 132, comme cela est représenté en figure 11B. Les lignes conductrices 134 et 135 reliées aux plots 131 et 132 sont alors mises en contact.

D'autres structures de micro-interrupteurs comprenant un condensateur variable selon la présente invention pourront être imaginées. On pourra entre autre prévoir de placer plusieurs plots conducteurs sous la couche conductrice en regard de plusieurs paires de plots conducteurs placées dans le fond du sillon 121 et reliées chacune à deux lignes conductrices.

Bien entendu, la présente invention est susceptible de diverses variantes et modifications qui apparaîtront à l'homme de l'art. En particulier, on pourra utiliser un condensateur selon la présente invention dans d'autres composants. De plus, l'homme de l'art pourra imaginer d'autres procédés de fabrication d'un condensateur selon la présente invention.

En outre, on pourra avantageusement réaliser sur un même circuit intégré plusieurs types de composants comprenant un condensateur selon la présente invention. Dans le cas par exemple d'un circuit comprenant des condensateurs variables et des résonateurs "montés" sur des condensateurs variables, on pourra réaliser l'ensemble des condensateurs simultanément en mettant en oeuvre la même série d'étapes de fabrication.

## Revendications

1. Condensateur variable comprenant :
- une portion de sillon (11 ; 45 ; 65) formée dans un substrat isolant (10 ; 40 ; 60), deux parties supérieures du substrat situées de chaque côté de la portion de sillon constituant deux bords latéraux (12, 13 ; 46, 47 ; 66, 67),
- une couche conductrice (15 ; 50 ; 68) recouvrant l'intérieur de la portion de sillon,
- une membrane souple (16 ; 51 ; 70), constituée d'un matériau conducteur, placée au-dessus de la portion de sillon en s'appuyant sur lesdits bords,
- une couche diélectrique (17 ; 52 ; 71) recouvrant la couche conductrice ou la membrane de façon à isoler les portions de la couche conductrice et de la membrane qui sont proches l'une de l'autre, et
- des bornes d'application d'une tension entre la couche conductrice et la membrane,
**caractérisé en ce que** la profondeur de la portion de sillon augmente continûment en allant d'un des bords vers le fond de la portion de sillon, et **en ce que** la couche conductrice recouvre l'intérieur de la portion de sillon au moins jusqu'à l'un des deux bords qu'elle recouvre éventuellement.

2. Condensateur selon la revendication 1, dans lequel ladite portion de sillon est une portion d'une cavité formée dans le substrat isolant.

3. Condensateur selon la revendication 1, dans lequel la couche conductrice (15 ; 50) recouvre l'intérieur de la portion de sillon (11 ; 45) jusqu'aux deux bords (12, 13 ; 46, 47).

4. Condensateur selon la revendication 1, dans lequel une tranchée (41) est formée dans le substrat (40), des espaceurs (42, 43) étant accolés contre deux parois opposées de la tranchée, l'espace de la tranchée non occupé par les espaceurs constituant ladite portion de sillon.

5. Condensateur selon la revendication 1, dans lequel une tranchée (61) est formée dans le substrat (60), un espaceur (62) étant accolé contre une des parois de la tranchée, l'espace de la tranchée non occupé par les espaceurs constituant ladite portion de sillon, ladite couche conductrice recouvrant ledit espaceur et une grande partie du fond de la portion de sillon située à proximité de l'espaceur, la partie du fond de la portion de sillon située à proximité de la paroi sans espaceur étant découverte.

6. Condensateur selon la revendication 1, dans lequel la membrane (16 ; 51 ; 70) est dans un état de repos quand aucune tension (V) n'est appliquée entre lesdites bornes, l'application d'une tension déformant la membrane en la rapprochant de la couche conductrice (15 ; 50 ; 68), la suppression de la tension ramenant la membrane dans son état de repos.

7. Condensateur selon la revendication 1, dans lequel ladite portion de sillon (81) comprend plusieurs parties (86, 87, 88) présentant des inclinaisons différentes.

8. Résonateur comprenant un condensateur selon la revendication 1, et comprenant en outre une couche piézoélectrique (105) posée sur la membrane souple (103), et une seconde couche conductrice (106) posée sur la couche piézoélectrique, ladite couche conductrice (102) et la seconde couche conductrice constituant les électrodes du résonateur.

9. Interrupteur comprenant un condensateur selon la revendication 1, et dans lequel ladite couche conductrice comprend deux portions disjointes (124, 125), chaque portion recouvrant un des côtés de la portion de sillon (121) jusqu'à un des bords (122, 123), ladite membrane comprend deux portions disjointes (126, 129) placées sensiblement au-dessus des deux portions de ladite couche conductrice, et ladite couche diélectrique (126) recouvre la surface inférieure de la membrane souple, et comprenant en outre au moins une paire de premiers plots conducteurs (131, 132) placés au fond de la portion de sillon entre les deux portions de la couche conductrice et au moins un second plot conducteur (133) encastré dans la couche diélectrique du côté de sa face inférieure, au-dessus des paires de premiers plots conducteurs, les seconds plots conducteurs étant susceptibles de mettre en contact les deux premiers plots de chaque paire après déformation de la membrane par application d'une tension entre la couche conductrice et la membrane.

10. Procédé de formation d'un condensateur variable comprenant les étapes suivantes :
- former une cavité dans un substrat isolant (26), une portion de cavité (25) ayant sensiblement la forme d'une portion de sillon, les parties supérieures du substrat situées à proximité de ladite portion de sillon constituant deux bords latéraux, la profondeur de la portion de sillon augmentant continûment en allant d'un des bords vers le fond de la portion de sillon ;
- recouvrir l'intérieur de la portion de sillon au moins jusqu'à un des bords et recouvrir éventuellement un ou deux bords d'une première couche conductrice (30) ;
- remplir la cavité d'une portion sacrificielle (31) ;
- recouvrir la portion sacrificielle, les parties supérieures du substrat et éventuellement les portions de la première couche conductrice placées au-dessus des bords latéraux d'une couche isolante (32) et d'une seconde couche conductrice (33) ;
- graver la couche isolante et la seconde couche conductrice de façon à conserver une portion en forme de pont passant par-dessus la portion de sillon et s'appuyant sur les bords latéraux ; et
- éliminer la portion sacrificielle.

11. Procédé selon la revendication 10, dans lequel l'étape de formation d'une cavité (25) dans un substrat isolant (26) comprend les étapes suivantes :
- former des plots isolants (20, 21) sur une couche support (22) ;
- recouvrir la couche support et les plots isolants d'une couche isolante (23) ; et
- effectuer un polissage mécano-chimique de la couche isolante jusqu'à découvrir les plots isolants, le procédé de gravure du polissage étant tel qu'il grave davantage la couche isolante que les plots isolants, les plots isolants constituant lesdits bords latéraux.

12. Procédé selon la revendication 10, comprenant en outre préalablement au remplissage de la cavité (25) d'une portion sacrificielle (31), une étape consistant à former des portions isolantes sur le bord de la cavité, le remplissage de la cavité consistant alors à déposer une couche sacrificielle sur l'ensemble de la structure et à effectuer ensuite un polissage mécano-chimique jusqu'à découvrir les portions isolantes.

13. Procédé selon la revendication 10, dans lequel l'étape consistant à former une cavité dans un substrat comprend les étapes suivantes :
- prévoir, sur un substrat isolant (90), un empilement de différentes couches isolantes (91, 92), une ouverture étant formée dans chacune des couches, les ouvertures étant superposées et de plus en plus grandes en s'éloignant du substrat, chaque ouverture étant placée de façon à découvrir entièrement l'ouverture sous-jacente ; et
- effectuer un polissage mécano-chimique de la structure précédemment obtenue en utilisant un procédé de gravure tel que les vitesses d'attaque des différentes couches isolantes soient différentes et augmentent en allant du substrat vers le haut de l'empilement.

## Claims

1. A variable capacitor comprising:
- a groove portion (11; 45; 65) formed in an insulating substrate (10; 40; 60), two upper portions of the substrate located on either side of the groove portion forming two lateral edges (12, 13; 46, 47; 66, 67),
- a conductive layer (15; 50; 68) covering the inside of the groove portion,
- a flexible membrane (16; 51; 70), formed of a conductive material, placed above the groove portion by bearing on said edges,
- a dielectric layer (17; 52; 71) covering the conductive layer or the membrane to insulate the portions of the conductive layer and of the membrane which are close to each other, and
- terminals of application of a voltage between the conductive layer and the membrane,
**characterized in that** the depth of the groove portion continuously increases from one of the edges to the bottom of the groove portion, and wherein the conductive layer covers the inside of the groove portion at least to reach one of the two edges, that it may cover.

2. The capacitor of claim 1, wherein said groove portion is a portion of a cavity formed in the insulating substrate.

3. The capacitor of claim 1, wherein the conductive layer (15; 50) covers the inside of the groove portion (11; 45) and reaches the two edges (12, 13; 46, 47).

4. The capacitor of claim 1, wherein a trench (41) is formed in the substrate (40), spacers (42, 43) being placed against two opposite walls of the trench, the trench space not taken up by the spacers forming said groove portion.

5. The capacitor of claim 1, wherein a trench (61) is formed in the substrate (60), a spacer (62) being placed against one of the trench walls, the trench space not taken up by the spacers forming said groove portion, said conductive layer covering said spacer and a large portion of the bottom of the groove portion located close to the spacer, the bottom portion of the groove portion located close to the wall with no spacer being exposed.

6. The capacitor of claim 1, wherein the membrane (16; 51; 70) is in an idle state when no voltage (V) is applied between said terminals, the application of a voltage deforming the membrane by drawing it closer to the conductive layer (15; 50; 68), the suppression of the voltage bringing the membrane back to its idle state.

7. The capacitor of claim 1, wherein said groove portion (81) comprises several portions (86, 87, 88) exhibiting different inclinations.

8. A resonator comprising the capacitor of claim 1, and further comprising a piezoelectric layer (105) resting on the flexible membrane (103), and a second conductive layer (106) resting on the piezoelectric layer, said conductive layer (102) and the second conductive layer forming the resonator electrodes.

9. A switch comprising the capacitor of claim 1, and wherein said conductive layer comprises two separate portions (124, 125), each portion covering one of the sides of the groove portion (121), reaching one of its edges (122, 123), said membrane comprises two separate portions (126, 129) substantially placed above the two portions of said conductive layer, and said dielectric layer (126) covers the lower surface of the flexible membrane, and further comprising at least one pair of first conductive pads (131, 132) placed at the bottom of the groove portion between the two portions of the conductive layer and at least one second conductive pad (133) inserted in the dielectric layer on its lower surface side, above the pairs of first conductive pads, the second conductive pads being likely to put in contact the first two pads of each pair after deformation of the membrane by application of a voltage between the conductive layer and the membrane.

10. A method for forming a variable capacitor comprising the steps of:
- forming a cavity in an insulating substrate (26), a cavity portion (25) substantially having the shape of a groove portion, the upper parts of the substrate located close to said groove portion forming two lateral edges, the depth of the groove portion increasing continuously from one of the edges to the bottom of the groove portion;
- covering the inside of the groove portion, at least to reach one of the edges and possibly covering one or two edges with a first conductive layer (30);
- filling the cavity with a sacrificial portion (31);
- covering the sacrificial portion, the upper substrate portions and possibly the portions of the first conductive layer placed above the lateral edges with an insulating layer (32) and with a second conductive layer (33);
- etching the insulating layer and the second conductive layer to keep a bridge-shaped portion running over the groove portion and bearing against the lateral edges; and
- removing the sacrificial portion.

11. The method of claim 10, wherein the step of forming a cavity (25) in an insulating substrate (26) comprises the steps of:
- forming insulating pads (20, 21) on a support layer (22) ;
- covering the support layer and the insulating pads with an insulating layer (23); and
- performing a chem./mech polishing of the insulating layer to expose the insulating pads, the etch method of the polishing being such that it etches more the insulating layer than the insulating pads, the insulating pads forming said lateral edges.

12. The method of claim 10, further comprising prior to the filling of the cavity (25) with a sacrificial portion (31), a step of forming insulating portions on the cavity edge, the cavity filling then consisting of depositing a sacrificial layer over the entire structure and then performing a chem./mech polishing to expose the insulating portions.

13. The method of claim 10, wherein the step of forming a cavity in a substrate comprises the steps of:
- providing, on an insulating substrate (90), a stacking of different insulating layers (91, 92), an opening being formed in each of the layers, the openings being superposed and larger and larger as they are further away from the substrate, each opening being placed to completely expose the underlying opening; and
- performing a chem. /mech polishing of the previously-obtained structure by using an etch method such that the etch speeds of the different insulating layers are different and increase from the substrate to the top of the stacking.

## Patentansprüche

1. Ein variabler Kondensator, wobei der Kondensator Folgendes aufweist:
einen Ausnehmungsteil (11; 45; 65), der in einem isolierenden Substrat (10; 40; 60) ausgebildet ist, wobei zwei obere Teile des Substrats jeweils an jeder Seite des Ausnehmungsteils Seitenkanten (12, 13; 46, 47; 66, 67) bilden,
eine leitende Schicht (15; 50; 68), die die Innenseite des Ausnehmungsteils bedeckt,
eine flexible Membran (16; 51; 70), die aus einem leitenden Material gebildet ist und oberhalb des Ausnehmungsteils auf den Kanten aufliegend angeordnet ist,
eine dielektrische Schicht (17; 52; 71), die die leitende Schicht oder die Membran bedeckt, um die Teile der leitenden Schicht und der Membran, die nahe beieinander liegen zu isolieren, und
Anschlüsse zum Anlegen einer Spannung zwischen der leitenden Schicht und der Membran,
**dadurch gekennzeichnet, dass** die Tiefe des Ausnehmungsteils kontinuierlich von einer der Kanten zu dem Grund des Ausnehmungsteils zunimmt, und wobei die leitende Schicht die Innenseite des Ausnehmungsteils bedeckt, wenigstens so, dass eine der beiden Kanten erreicht wird, die sie bedecken kann.

2. Der Kondensator nach Anspruch 1, wobei der Ausnehmungsteil ein Teil einer Kavität ist, die in dem isolierenden Substrat ausgebildet ist.

3. Der Kondensator nach Anspruch 1, wobei die leitenden Schicht (15; 50) die Innenseite des Ausnehmungsteils (11; 45) bedeckt und die zwei Kanten (12, 13; 46, 47) erreicht.

4. Der Kondensator nach Anspruch 1, wobei ein Graben (41) in dem Substrat (40) ausgebildet ist, und Abstandshalter (42, 43), die an zwei gegenüberliegenden Wänden der Rinne angeordnet sind, wobei der Rinnenraum, der nicht von den Abstandhaltern eingenommen ist, den Ausnehmungsteil bildet.

5. Der Kondensator nach Anspruch 1, wobei ein Graben (61) in dem Substrat (60) ausgebildet ist, ein Abstandshalter (62), der an einer der Wände des Grabens angeordnet ist, wobei der Grabenraum, der nicht von den Abstandshaltern eingenommen wird, den Ausnehmungsteil bildet, wobei die leitende Schicht den Abstandshalter und einen großen Teil des Grunds des Ausnehmungsteils, der nah bei dem Abstandshalter liegt, bedeckt, wobei der Grundteil des Ausnehmungsteils, der nah bei der Wand ohne Abstandshalter liegt, frei liegt.

6. Der Kondensator nach Anspruch 1, wobei die Membran (16; 51; 70) in einem Leerlaufzustand ist, wenn keine Spannung (V) zwischen den Anschlüssen angelegt ist, wobei das Anlegen einer Spannung die Membran durch das Ziehen der Membran näher an die leitende Schicht (15; 50; 68) deformiert, wobei die Unterdrückung der Spannung die Membran zurück in ihren Leerlaufzustand bringt.

7. Der Kondensator nach Anspruch 1, wobei der Ausnehmungsteil (81) mehrere Teile (86, 87, 88) mit unterschiedlicher Neigung aufweist.

8. Ein Resonator, der den Kondensator nach Anspruch 1 aufweist, und wobei der Resonator ferner eine piezoelektrische Schicht (105) aufweist, die auf der flexiblen Membran (103) liegt, und eine zweite leitende Schicht (106), die auf der piezoelektrischen Schicht liegt, wobei die leitende Schicht (102) und die zweite leitende Schicht die Elektroden des Resonators bilden.

9. Ein Schalter, der den Kondensator nach Anspruch 1 aufweist, und wobei die leitende Schicht zwei getrennte Teile (124, 125) aufweist, wobei jeder Teil eine der Seiten des Ausnehmungsteils (121) bedeckt, und eine seiner Kanten (122, 123) erreicht, wobei die Membran zwei getrennte Teile (126, 129) aufweist, die im Wesentlichen über den zwei Teilen der leitenden Schicht angeordnet sind, und wobei die dielektrische Schicht (126) die untere Fläche der flexiblen Membran bedeckt, und ferner wenigstens ein Paar von ersten leitenden Auflagen (131, 132) aufweist, die an dem Grund des Ausnehmungsteils zwischen den zwei Teilen der leitenden Schicht angeordnet sind und wenigstens eine zweite leitende Auflage (133), die in die dielektrische Schicht an ihrer Unterseite eingebracht ist, über dem Paar der ersten leitenden Auflagen, wobei die zweite leitende Auflage die ersten zwei Auflagen jedes Paares nach der Deformation der Membran durch das Anlegen einer Spannung zwischen der leitenden Schicht und der Membran wahrscheinlich in Kontakt bringen wird.

10. Ein Verfahren zum Ausbilden eines variablen Kondensators, wobei das Verfahren die Folgenden Schritte aufweist:
Ausbilden einer Kavität in einem isolierenden Substrat (26), wobei ein Kavitätsteil (25) im Wesentlichen die Form eines Ausnehmungsteils hat, wobei die oberen Teile des Substrats, die nahe dem Ausnehmungsteil liegen, seitliche Kanten bilden, wobei die Tiefe des Ausnehmungsteils kontinuierlich von einer der Kanten zu dem Grund des Ausnehmungsteils zunimmt;
Bedecken der Innenseite des Ausnehmungsteils, wenigstens so dass eine der Kanten erreicht wird und eventuell Bedecken von ein oder zwei Kanten mit einer ersten leitenden Schicht (30);
Füllen der Kavität mit einem Opferteil (31);
Bedecken des Opferteils, der oberen Substratteile und eventuell der Teile der ersten leitenden Schicht, die zwischen den seitlichen Kanten angeordnet ist, mit einer isolierenden Schicht (32) und mit einer zweiten leitenden Schicht (33);
Ätzen der isolierenden Schicht und der zweiten leitenden Schicht, um einen brückenförmigen Teil zu behalten, der über den Ausnehmungsteil verläuft und sich an den seitlichen Kanten abstützt; und
Entfernen des Opferteils.

11. Das Verfahren nach Anspruch 10, wobei der Schritt des Ausbildens einer Kavität (25) in einem isolierenden Substrat (26), die Folgenden Schritte aufweist:
Ausbilden von isolierenden Auflagen (20, 21) auf einer Trägerschicht (22);
Bedecken der Trägerschicht und der isolierenden Auflagen mit einer isolierenden Schicht (23); und
Ausführen eines chemischen/mechanischen Polierens der isolierenden Schicht, um die isolierenden Auflagen frei zu legen, wobei das Ätzverfahren des Polierens derart ist, dass es mehr die isolierende Schicht ätzt, als die isolierenden Auflagen, wobei die isolierenden Auflagen die seitlichen Kanten bilden.

12. Das Verfahren nach Anspruch 10, wobei das Verfahren ferner vor dem Füllen der Kavität (25) mit einem Opferteil (31), einen Schritt des Ausbildens eines isolierenden Teils an der Kavitätskante aufweist, wobei das Füllen der Kavität dann aus dem Ablagern einer Opferschicht über der gesamten Struktur besteht und dann aus dem Ausführen eines chem./mech. Polierens, um die isolierenden Teile frei zu legen.

13. Das Verfahren nach Anspruch 10, wobei der Schritt des Ausbildens einer Kavität in einem Substrat die folgenden Schritte aufweist:
Bereitstellen, auf einem isolierenden Substrat (90), einen Stapel von unterschiedlichen isolierenden Schichten (91, 92), wobei eine Öffnung in jeder der Schichten ausgebildet ist, wobei die Öffnungen übereinanderliegen und größer und größer werden je weiter sie von dem Substrat entfernt sind, wobei jede Öffnung so angeordnet ist, dass sie die darunterliegende Öffnung vollständig frei legt; und
Ausführen eines chemischen/mechanischen Polierens der vorher erhaltenen Struktur durch das Anwenden eines Ätzverfahrens, derart, dass die Ätzgeschwindigkeit der unterschiedlichen isolierenden Schichten unterschiedlich sind und von dem Substrat zu der Spitze des Stapels zunehmen.
